# EUROPEAN PATENT APPLICATION

(11) **EP 0 643 295 A2**
(43) Date of publication of application: **15.03.1995**
(21) Application number: 94306516.9
(22) Date of filing: 05.09.1994
(51) Int. Cl.: G12B 5/00, G12B 9/00, F16M 13/00, G01N 21/90, B07C 5/12, F16D 71/04

(54) **Container inspecting machine**

(30) Priority: 15.09.1993 US 121819
(71) Applicant: Emhart Glass Machinery Investments Inc., Wilmington, Delaware 19801 (US)
(72) Inventor: Emery, Monti D., Elmira, New York 14903 (US)
(74) Representative: Randall, John Walter

(57) **Abstract**

A machine for inspecting containers is disclosed which has a lower cabinet for enclosing a container as it is conveyed therethrough for inspection. A monitor module 24 is supported 34 for displacement between an up position above the lower cabinet and an operative position in front of the lower cabinet. A force 50 for resisting the displacement of the supported monitoring module is defined at any location between the up and operative positions.

## Description

Containers such as glass bottles may be formed with defects which make the container unacceptable. To identify unacceptable bottles, the bottles are conveyed through one or more inspection stations. Among current inspections are inner and outer finish (threaded area), top surface of finish, and wall thickness inspection.

State of the art machines are electronically controlled with pendant controls that are supported for displacement by the operator to locate the control at a convenient location. The pendant control support is conventionally secured to a suitable pedestal or beam.

It is an object of the present invention to provide an improved pendant control for a container inspecting machine.

The invention generally comprises a machine for inspecting containers comprising
a lower cabinet for enclosing a container as it is conveyed therethrough,
a monitor module,
means for supporting said monitor module for displacement between an up position above said lower cabinet and an operative position in front of said lower cabinet, and
said supporting means including means for defining a force for resisting the displacement of said supported monitor module at any location between said up and operative positions.

Other objects and advantages of the present invention will become apparent from the following portion of this specification and from the accompanying drawings which illustrate in accordance with the mandate of the patent statutes a presently preferred embodiment incorporating the principles of the invention.

Referring to the drawings:
Figure 1 is a front view of a container inspecting machine made in accordance with the teachings of the present invention;
Figure 2 is a left side view of a portion of the machine shown in Figure 1;
Figure 3 is a view similar to that of Figure 2 with the monitor module of the machine displaced to an operative position; and
Figure 4 is a top view illustrating the structure for supporting the monitor module for displacement between the up and down operative positions.

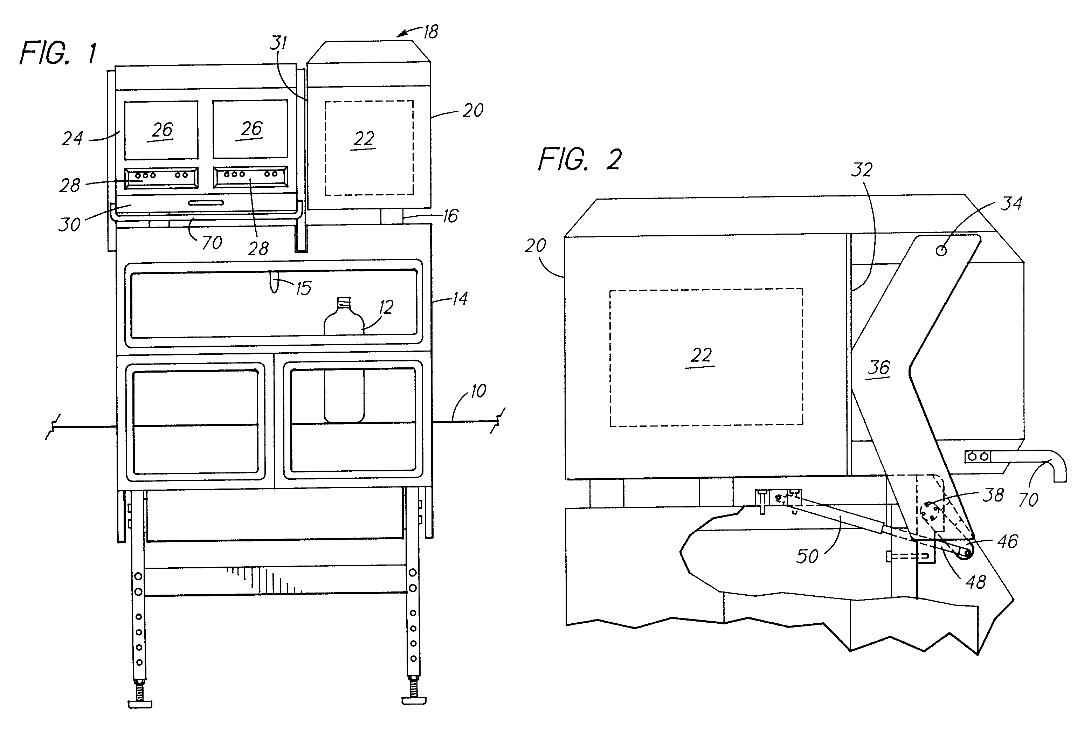

A machine for inspecting containers is shown in Figure 1. A conveyor 10 runs through the inspection machine carrying containers 12 like glass bottles through one or more inspection stations. The lower cabinet or enclosure 14 encloses the inspection device or devices (a plug gage 15 is shown) and also encloses the handling mechanism, here, the conveyor. Secured above this lower cabinet on four posts 16 is an upper control cabinet 18 which has a fixed portion 20 houses the electronic components for operating the machine. These may include a controller (a computer), power supplies, rack mounted circuit boards, cooling structures and motor controllers, for example. Such enclosed structure is shown schematically as item 22.

The upper enclosure or cabinet 18 also includes a displaceable monitor module 24 which, as shown, has two screens 26, associated control panels 28 and a pull out keyboard 30. In the fully up position illustrated in Figures 1 and 2, the monitor module 24 is a part of the upper cabinet or enclosure 18 being located within a pocket having side 30 and rear walls 32 defined in the fixed upper cabinet portion 20.

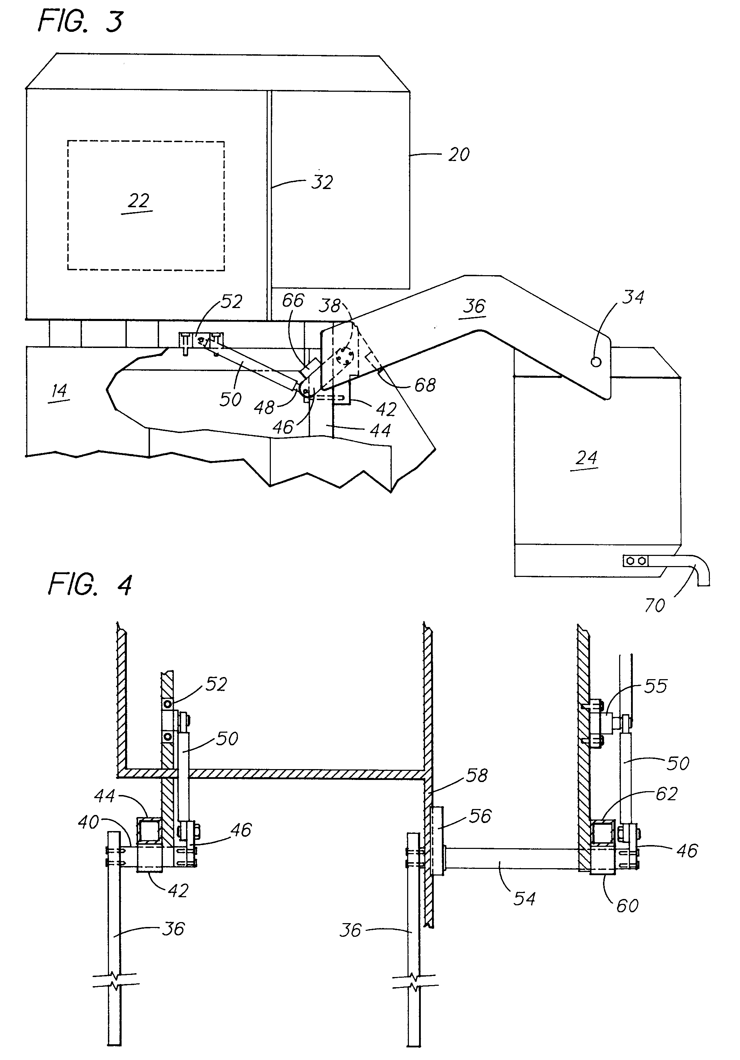

Pivotally secured to pins 34 on opposite sides of the monitor module 24, proximate its top, are matched pairs of support brackets 36. The outboard bracket 36 is secured with four screws 38 to a shaft 40 (Figure 4) rotatably supported by a bushing 42 secured to a frame member 44. Secured to the other end of the shaft in a similar manner, is one end of a control lever 46. The other end of the control lever is pivotally secured to the rod 48 of a gas charged (about 250 lbs) cylinder 50. The other end of the cylinder is pivotally secured to the frame via the outboard bracket 52. The inboard bracket 36 is similarly secured to an elongated shaft 54 which is rotatably supported between a left hand bushing 56 secured to a frame wall 58 and a right hand bushing 60 which is secured to a frame member 62. A matched control lever 46 interconnects the rod 48 of a second charged cylinder 50 and the shaft 54 and a second bracket 55 rotatably supports the other end of the cylinder 50. Fixed stops 66, 68 limit the displacement of the control levers 46 between 90° related monitor module fully up and fully down positions.

An operator displacement force (the operator can move the monitor module by pulling on handle 70) which is less than about 20 lbs (the maximum desirable force) and which is sufficient at any location along its displacement to hold the monitor module at that position is achieved. As shown in Figure 1, when the weight moment of the monitor module is small (the pivot connection 34 to the monitor module is slightly forward of the pivot shaft 40 supporting the support brackets 36) the rods 44 make a very small angle with the control levers 46. As this moment increases (the monitor module is lowered) the effective length of each of the control levers as the moment arm increases.

To prevent rocking of the monitor module at the down position, a detent in the form of a ball plunger (not shown) secured to the support brackets can be used.

## Claims

1. A machine for inspecting containers 12 comprising a lower cabinet 14 for enclosing a container as it is conveyed 10 therethrough, and a monitor module 24, characterized by
means 36 for supporting said monitor module 24 for displacement between an up position above said lower cabinet 14 and an operative position in front of said lower cabinet 14, and
said supporting means including means 50 for defining a force for resisting the displacement of said supported monitor module at any location between said up and operative positions.

2. A machine for inspecting containers according to claim 1, characterized in that said force defining means 50 comprises a charged cylinder.

3. A machine for inspecting containers according to claim 1, characterized in that said supporting means comprises a pair of brackets 36 pivotally secured 34 at one end to a side of said monitor module and pivotally secured 40 at the other end to said lower cabinet.

4. A machine for inspecting containers according to claim 3, characterized in that said force defining means includes
a pair of charged cylinders 50, each pivotally secured 40 to said lower cabinet and each having an extendable rod 48, and
a pair of control levers 46, each secured at one end to the other end of one of said brackets and pivotally secured at the other control lever end to one of said rods.

5. A machine for inspecting containers according to claim 1, further comprising an upper cabinet including a pocket 30, 32 for receiving said monitor module 24 when it is displaced to said up position.
